# FASCICULE DE BREVET EUROPEEN

(11) **EP 4 276 880 B1**
(45) Date de publication et mention de la délivrance du brevet: **19.02.2025**
(21) Numéro de dépôt: 22172494.1
(22) Date de dépôt: 10.05.2022
(51) Int. Cl.: H01J 37/32, G04B 19/06, G04B 37/22, H01L 21/3065, G04B 19/12

(54) **PROCÉDÉ DE MODIFICATION DE L ÉTAT DE SURFACE D'UNE PIÈCE PAR BOMBARDEMENT IONIQUE**
VERFAHREN ZUR ÄNDERUNG DES OBERFLÄCHENZUSTANDS EINES WERKSTÜCKS DURCH IONENBESCHUSS
METHOD FOR MODIFYING THE SURFACE CONDITION OF A PART BY ION BOMBARDMENT

(43) Date de publication de la demande: 15.11.2023
(73) Titulaire: Rubattel et Weyermann S.A., 2300 La Chaux-de-Fonds (CH)
(72) Inventeur: POLY, Giovanni, 25140 Charquemont (FR); BARBOS, Corina, 2300 La Chaux-de-Fonds (CH); JEANRENAUD, Frédéric, 2300 La Chaux-de-Fonds (CH)
(74) Mandataire: ICB SA

(56) Documents cités:
- EP-A1- 3 556 911
- EP-A2- 3 375 903
- CH-A5- 692 151
- US-A- 5 895 558

## Description

### Domaine technique de l'invention

L'invention relève du domaine des traitements de surface, et concerne en particulier un procédé de modification de l'état de surface d'une surface d'une pièce par bombardement ionique.

### Arrière-plan technologique

Dans certaines applications, notamment pour des raisons d'ordre esthétique en ce qui concerne des pièces d'habillage, il est recherché d'obtenir une surface visible présentant un aspect mat, c'est-à-dire non brillant.

En d'autres termes, il est recherché de matifier, c'est à dire d'augmenter la matité, de la surface de certaines pièces d'habillage.

Généralement, un aspect mat d'une surface d'une pièce est obtenu en augmentant sa rugosité. En effet, la brillance d'une surface dépend de son niveau de réflexion du rayonnement lumineux. En particulier, une surface dont l'aspect est brillant réfléchit la lumière de façon spéculaire, et une surface dont l'aspect est mat réfléchit la lumière de façon diffuse.

Pour matifier une surface d'une pièce, des solutions connues consistent à projeter sur la surface des particules de matériau abrasif, dont la granulométrie varie en fonction du rendu souhaité, avec une pression définie et pendant une durée donnée. Les particules de matériau abrasif peuvent être des billes de verre, de céramique, d'oxyde d'aluminium, etc.

Ces solutions présentent toutefois comme inconvénient l'usure des matériaux abrasifs et la nécessité d'un traitement de déchet particulier suite à leur utilisation. En effet, les particules de matériau abrasif sont polluées avec des particules de matériau de la pièce dont la surface est à matifier suite à leur utilisation. En outre, il existe un risque important que des disparités existent sur les granulométries des particules de matériau abrasif. Enfin, suivant l'épaisseur de la pièce, la projection de particules peut la déformer ou la détériorer de façon irréversible.

Dans d'autres cas, la nature du matériau de toute ou partie de la pièce peut être modifiée de sorte à matifier sa surface. Notamment, dans le cas dans lequel la surface à matifier est la surface d'une couche de vernis déposée sur la pièce, des additifs ou des résines appropriées peuvent être ajoutées à la composition du vernis.

Toutefois, cette solution est limitée car elle ne s'applique que dans le cas d'une surface d'une couche de vernis. Par ailleurs, suite à la modification de sa composition, la couche de vernis est susceptible de ne plus respecter certaines exigences, telle que des exigences de résistance à des contraintes mécaniques ou chimiques, des limites de résistance à certaines températures, des exigences de résistance à l'exposition au rayonnement ultraviolet, etc. Un autre inconvénient de cette solution est d'ajouter une étape supplémentaire dans la réalisation d'une pièce d'habillage consistant à modifier la composition du vernis, ce qui est particulièrement contraignant lorsqu'une telle pièce doit être produite de façon industrielle.

Le document EP3556911 A1 décrit un procédé de structuration au moyen d'un faisceau d'ions. Le document CH692151 A5 divulgue un procédé de dépôt d'un revêtement d'un objet comprenant une étape de décapage ionique afin d'améliorer l'adhérence des couches PVD, les ions étant produits par un plasma d'argon et le bombardement durant plusieurs minutes. Le document EP3375903 A2 divulgue un procédé de fabrication d'une pièce d'horlogerie constituée d'un substrat et d'une couche de film mince, dans lequel un traitement de surface par plasma est effectué sur le substrat ou le film mince pour que le pourcentage de surface de la surface visible de la pièce augmente et que la pièce devienne modérément brillante. Le document US5895558 A divulgue l'utilisation combinée d'un rayonnement UV et d'un bombardement ionique dans le cadre d'un procédé de traitement d'un film polymère à pression atmosphérique.

### Résumé de l'invention

L'invention résout les inconvénients précités en proposant une solution permettant de matifier une surface cible, c'est-à-dire d'augmenter sa matité, sans créer d'oxyde sur ladite surface, ni de revêtement.

Autrement dit, la présente invention permet de modifier uniquement l'état de surface de la surface cible afin de la matifier.

À cet effet, la présence invention concerne un procédé de traitement d'une surface cible d'une pièce par plasma, en accord avec la revendication 1, comportant les étapes suivantes :
- obtention de la surface cible sur la pièce, comprenant une opération de dépôt d'une couche de vernis sur une zone dédiée de la surface cible et une opération de pré-réticulation d'au moins une partie de la couche de vernis par exposition d'au moins une partie de la surface cible à un rayonnement ultraviolet,
- mise en place de la pièce dans une enceinte d'un générateur à plasma,
- mise sous vide de l'enceinte, à une pression comprise entre 10⁻⁶ et 10 mbar,
- injection d'un gaz adapté dans l'enceinte jusqu'à atteindre une pression dans l'enceinte comprise entre 10⁻⁴ et 10² mbar,
- génération d'une décharge de courant électrique au sein de l'enceinte, par l'intermédiaire d'un générateur électrique, afin de générer un plasma,
- exposition de la surface cible de la pièce au plasma durant une durée prédéfinie notamment selon la puissance de la décharge de courant électrique, le gaz injecté dans l'enceinte et le matériau de la surface cible, de sorte à modifier l'état de surface de la surface cible afin d'augmenter sa rugosité pour rendre ladite surface cible mat ou davantage mat, c'est à dire pour la matifier, ladite étape d'exposition de la surface cible de la pièce au plasma étant réalisée de sorte à finir la réticulation de la partie de la couche de vernis pré-réticulée.

Dans des modes particuliers de mise en œuvre, l'invention peut comporter en outre l'une ou plusieurs des caractéristiques suivantes, prises isolément ou selon toutes les combinaisons techniquement possibles.

Dans des modes particuliers de mise en œuvre, lors de l'opération de pré-réticulation, la surface cible est exposée au rayonnement ultraviolet durant 5 à 10 secondes.

Dans des modes particuliers de mise en œuvre, l'enceinte est mise sous vide à une pression comprise entre 0,1 et 1 mbar.

Dans des modes particuliers de mise en œuvre, lors de l'étape d'injection d'un gaz, de l'argon est injecté. Ce gaz est injecté dans l'enceinte avec un débit massique compris entre 15 et 25 sccm, jusqu'à obtenir une pression dans l'enceinte comprise entre 0,6 et 0,8 mbar.

Avantageusement, le choix de l'argon comme gaz à partir duquel le plasma est généré permet d'affecter la surface cible uniquement mécaniquement. Autrement dit, le plasma ne dégrade pas chimiquement l'état de surface de la surface cible.

Dans des modes particuliers de mise en œuvre, le générateur électrique développe une puissance comprise entre 2000 et 2600 W lors de l'étape de génération d'une décharge de courant électrique et l'étape d'exposition de la surface cible est réalisée durant 1 à 2 minutes.

Dans des modes particuliers de mise en œuvre, la couche de vernis présente une unité de brillant mesurée à 60° inférieure à 5 GU.

Dans des modes particuliers de mise en œuvre, à l'issue de l'étape d'obtention de la surface cible sur la pièce, une étape de dépôt d'une couche de masquage est réalisée sur une partie de la surface cible dite « zone masquée », le reste de ladite surface cible étant dite « zone exposée », ladite couche de masquage étant destinée à protéger la zone masquée du plasma.

Dans des modes particuliers de mise en œuvre, lors de l'opération de pré-réticulation de la couche de vernis, seule une partie de ladite couche est pré-réticulée, l'autre partie étant entièrement réticulée.

### Brève description des figures

D'autres caractéristiques et avantages de l'invention apparaîtront à la lecture de la description détaillée suivante donnée à titre d'exemple nullement limitatif, en référence aux dessins annexés dans lesquels :
- les figures 1 à 4 représentent schématiquement différentes étapes successives d'un procédé de traitement d'une surface cible d'une pièce par plasma selon un exemple préféré de mise en œuvre de l'invention ;
- la figure 5 représente schématiquement une vue en coupe transversale d'une étape d'exposition de la surface cible de la pièce au plasma selon une variante de l'exemple préféré de mise en œuvre du procédé selon l'invention ;
- la figure 6 représente schématiquement une vue en coupe transversale d'une étape d'exposition de la surface cible de la pièce au plasma selon un autre exemple de mise en œuvre du procédé selon l'invention .

On note que les figures ne sont pas dessinées à l'échelle pour des raisons de clarté.

### Description détaillée de l'invention

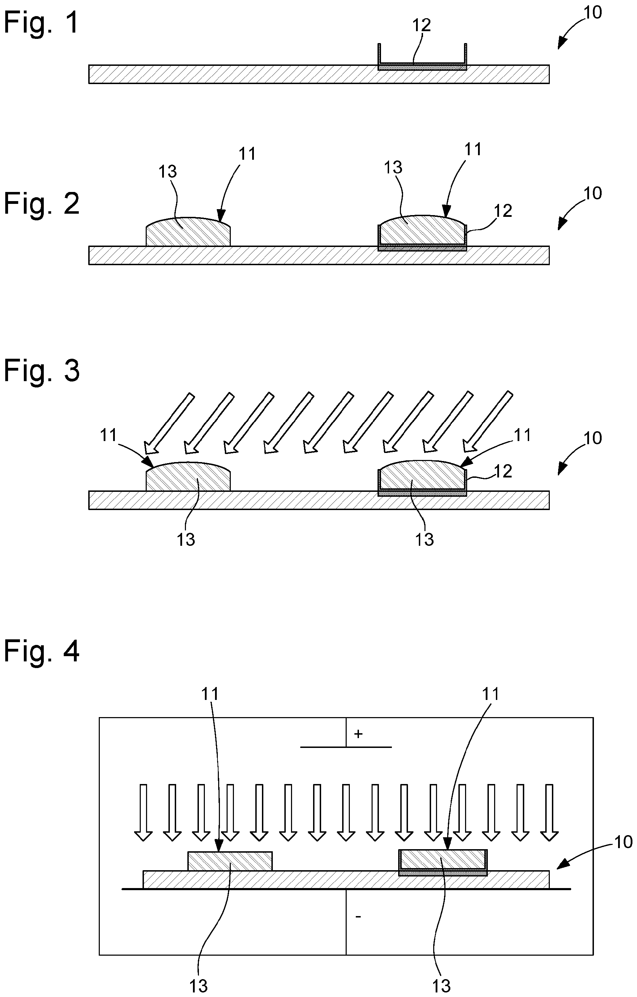

Les figures 1 à 4 représentent schématiquement différentes étapes successives d'un procédé de traitement d'une surface cible **11** d'une pièce 10 par plasma, selon un exemple préféré de mise en œuvre de la présente invention.

Le procédé selon l'invention a pour objectif de matifier la surface cible **11.**

Le procédé comprend une étape préliminaire d'obtention de la surface cible **11** sur la pièce 10.

Cette étape préliminaire peut comporter des opérations de dépôt d'un revêtement, par exemple un revêtement galvanique, de pose d'une applique, d'impression d'un décor, de lavage, etc.

La figure 1 illustre schématiquement une pièce 10 comprenant une applique 12 destinée à recevoir une couche de vernis 13.

Dans l'exemple de mise en œuvre de l'invention, lors de cette première étape, une opération de dépôt d'une couche de vernis 13 sur une zone dédiée d'une surface d'habillage de la pièce 10 est réalisée, comme le représente la figure 2. Plus précisément, la zone dédiée peut être formée sur l'applique 12 préalablement posée sur la surface d'habillage de la pièce et/ou directement sur la surface d'habillage de la pièce 10, tel qu'illustré sur les figures 2 à 5.

Toujours lors de cette étape préliminaire, cette opération de dépôt d'une couche de vernis 13 est suivie d'une opération de pré-réticulation de la couche de vernis 13 par exposition à un rayonnement ultraviolet, tel que représenté sur la figure 3. La surface cible **11** est, dans cet exemple de réalisation de l'invention, la surface visible de la couche de vernis 13.

La couche de vernis 13 peut être déposée manuellement par un opérateur ou de façon automatisée par un robot adapté. Par ailleurs, la couche de vernis 13 peut comporter une résine synthétique, acrylique, polyuréthane, polyépoxyde, un matériau luminescent, etc.

Durant l'opération de pré-réticulation de la couche de vernis 13, la surface cible **11** peut être exposée au rayonnement ultraviolet durant quelques secondes ou dizaines de secondes, préférentiellement entre 5 et 10 secondes.

Le rayonnement ultraviolet peut être émis par tout moyen connu de l'homme du métier, tel qu'une diode électroluminescente, une lampe à décharge au mercure, etc., de sorte à présenter une longueur d'onde comprise entre 100 et 400 nm.

Une fois la surface cible 11 obtenue, la pièce 10 est mise en place dans une enceinte d'un générateur à plasma 20, comme le montre la figure 4. En particulier, la pièce 10 est disposée sur une électrode d'un générateur électrique du générateur à plasma 20, directement ou par l'intermédiaire d'un support. Préférentiellement, la pièce 10 est disposée sur l'électrode négative du générateur à plasma 20, en vis-à-vis de l'électrode positive.

Le procédé selon l'invention comporte ensuite une étape de mise sous vide de l'enceinte par une pompe à vide connue en tant que telle de l'homme du métier. Les termes « mise sous vide » signifient ici, par abus de langage, que l'enceinte est mise à basse pression, typiquement à une pression comprise entre 10⁻⁶ et 10 mbar, et préférentiellement entre 0,1 et 1 mbar.

Une étape d'injection d'un gaz est alors mise en œuvre, jusqu'à atteindre une pression de travail dans l'enceinte comprise entre 10⁻⁴ et 10² mbar, et préférentiellement entre 0,6 et 0,8 mbar.

Le gaz est par exemple injecté à un débit massique compris entre 15 et 25 sccm jusqu'à ce que l'enceinte présente la pression de travail.

Une étape de génération d'une décharge d'un courant électrique au sein de l'enceinte est réalisée, par l'intermédiaire du générateur électrique, afin de générer un plasma dans ladite enceinte. Le flux de plasma est avantageusement dirigé vers la pièce 10, de sorte à provoquer un bombardement d'ions sur la surface cible 11, tel qu'illustré schématiquement sur la figure 4. En particulier, la différence de potentiel entre les électrodes du générateur électrique provoque l'ionisation des atomes du gaz et le bombardement de la surface cible 11 de la pièce 10 par lesdits ions.

Le gaz utilisé, adapté à la mise en œuvre du procédé selon l'invention, peut être choisi parmi Ar, He, O₂, CO, CO₂, H₂, Cl₂, CF₄, Ne, N₂ et NO₂. L'Ar est le gaz préféré dans la mesure où il est facilement ionisable, ce qui permet la génération d'un plasma avec un apport réduit en électricité. Par ailleurs, l'effet du plasma sur la surface cible 11 est plus important lorsqu'il est réalisé avec de l'Ar, dans le sens où ledit plasma est particulièrement adapté à modifier l'état de surface de la surface cible 11 et à réticuler une éventuelle couche de vernis 13 déposée sur la pièce 10. Enfin, l'Ar présente l'avantage d'être peu onéreux et facile à obtenir.

La surface cible 11 est exposée au plasma durant une durée prédéfinie notamment selon la puissance de la décharge de courant électrique, selon le gaz injecté dans l'enceinte et selon le matériau de la surface cible 11, de sorte à altérer l'état de surface de ladite surface cible 11 pour augmenter sa rugosité et ainsi sa matité. Dans la présente invention, l'exposition de la surface cible 11 au plasma, et en particulier au bombardement d'ions, a pour effet de modifier l'état de surface de ladite surface cible 11 par action mécanique ou par action physico-chimique, suivant le gaz injecté dans l'enceinte.

Dans l'exemple de mise en œuvre de la présente invention, l'étape d'exposition au plasma de la surface cible 11 de la pièce 10 est réalisée de sorte à achever la réticulation de la couche de vernis 13.

A titre d'exemple, lors de l'étape de génération d'une décharge de courant électrique, le générateur électrique peut développer une puissance comprise entre 2000 et 2600 W et la surface cible 11 peut être exposée durant 1 à 2 minutes.

Encore à titre d'exemple, à l'issu de la mise en œuvre du procédé, la couche de vernis 13 présente une unité de brillant, mesurée à 60°, inférieure à 5 GU. Autrement dit, les paramètres mentionnés ci-avant ont spécifiquement été déterminés par les inventeurs de sorte que la surface cible 11 de la couche de vernis 13 présente une telle unité de brillant.

Un des avantages de la présente invention est de permettre, dans un même temps, la réticulation de la couche de vernis 13 et la matification de la surface cible 11, lors de l'exposition de la pièce 10 au plasma. Ainsi, en plus de générer un gain de temps de production important en évitant la réalisation d'une étape ultérieure de réticulation, la présente invention permet de réduire le temps d'exposition au rayonnement ultraviolet, et permet ainsi de limiter les risques liés à l'utilisation de rayonnements ultraviolets.

La présente invention permet, en outre, quel que soit l'exemple de réalisation de l'invention considéré, d'augmenter la matité de toute surface, quel que soit son état de surface, par exemple même si elle présente des cavités de dimension submicrométrique ou micrométrique.

Avantageusement, à l'issue de l'étape d'obtention de la surface cible 11 sur la pièce 10, une étape de dépôt d'une couche de masquage peut être réalisée sur une partie de la surface cible 11 dite « zone masquée », le reste de ladite surface cible 11 étant dite « zone exposée ». Ladite couche de masquage est destinée à protéger la zone masquée des effets du plasma, de sorte à obtenir une pièce 10 dont la surface cible 11 présente deux niveaux de brillance différents.

Cette étape de dépôt d'une couche de masquage permet donc d'obtenir une pièce 10 dont la surface cible 11 est à la fois brillante et mate.

La couche de masquage peut être réalisée par un revêtement polymère, un revêtement galvanique ou un revêtement réalisé par une méthode de dépôt physique en phase vapeur.

Suite à l'étape d'exposition de la surface cible 11 au plasma, la couche de masquage peut être retirée par une solution adaptée à la nature du revêtement déposé. Par exemple, si la couche de masquage est réalisée en matériau polymère, elle peut être retirée avec un solvant adapté, si elle est réalisée en matériau métallique, elle peut être retirée avec une solution acide, etc.

Le cas échéant, la partie de la couche de vernis 13 protégée par la couche de masquage peut être réticulée dans une étape ultérieure de réticulation.

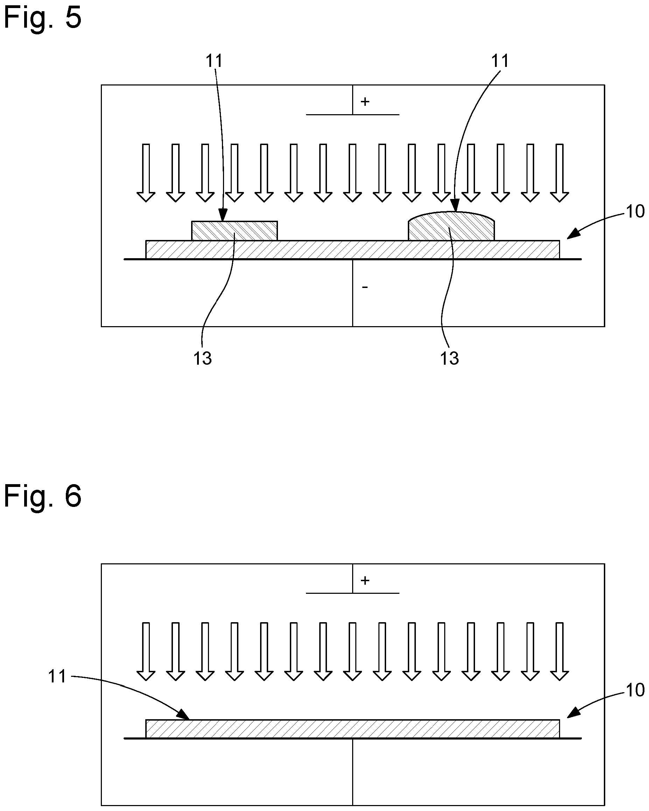

Dans l'exemple de mise en œuvre de l'invention, lors de l'opération de pré-réticulation de la couche de vernis 13, seule une partie de ladite couche de vernis 13 peut être pré-réticulée, l'autre partie étant alors entièrement réticulée. La partie de la couche de vernis 13 entièrement réticulée n'étant pas réticulée par le plasma, son état de surface n'est pas modifié ou est modifié de façon non perceptible à l'œil nu, tel que le représente schématiquement la figure 5.

Une telle caractéristique permet d'obtenir une pièce 10 dont la surface cible 11 présente différents niveaux de brillance, et ce alternativement au dépôt d'une couche de masquage.

Dans un exemple de réalisation représenté de façon schématique sur la figure 6, à la différence de l'exemple de réalisation représenté sur les figures 1 à 4, la surface cible 11 est formée par la surface de la pièce 10 ou par la surface d'un revêtement de ladite pièce 10. Autrement dit, dans cet exemple de mise en œuvre de la présente invention, la surface à matifier est celle de la pièce 10 ou d'un revêtement de la pièce 10, et non celle d'un vernis 13 déposé sur la pièce 10.

Un tel exemple de réalisation est particulièrement adapté lorsque la surface cible 11 est une surface d'une pièce réalisée en alliage de métaux, tel qu'en alliage de cuivre, de fer, d'aluminium, de titane, etc., en céramique, tel qu'en matériau métallique couplé à des oxydes, des nitrites ou des silicates, en matériau composite ou encore en matériau polymère. Cet exemple de réalisation de l'invention est également particulièrement adapté lorsque la surface cible 11 est une surface d'un revêtement de la pièce 10 réalisé en or, en argent, en nickel, cuivre, rhodium, ruthénium, argent, etc.

Suivant le matériau de la pièce 10 ou du revêtement de la pièce 10 présentant la surface cible 11, les valeurs des paramètres du procédé selon l'invention peuvent varier. Par exemple, le débit massique d'injection du gaz dans l'enceinte peut atteindre jusqu'à 1000 sccm, la puissance du générateur électrique peut atteindre jusqu'à 4 kW, la durée de l'exposition au plasma peut être comprise entre quelques secondes et quelques minutes, par exemple entre 5 secondes et 10 minutes.

La présente invention trouve une application avantageuse dans le domaine de l'horlogerie, en particulier lorsque la pièce 10 est une pièce 10 d'habillage d'une montre, par exemple un cadran.

De manière plus générale, il est à noter que les modes de mise en œuvre et de réalisation considérés ci-dessus ont été décrits à titre d'exemples non limitatifs, et que d'autres variantes sont par conséquent envisageables. L'invention est définie par les revendications.

## Revendications

1. Procédé de traitement d'une surface cible (11) d'une pièce (10) par plasma comportant les étapes suivantes :
- obtention de la surface cible (11) sur la pièce (10), comprenant une opération de dépôt d'une couche de vernis (13) sur une zone dédiée de la surface cible (11) et une opération de pré-réticulation d'au moins une partie de la couche de vernis (13) par exposition d'au moins une partie de la surface cible (11) à un rayonnement ultraviolet,
- mise en place de la pièce (10) dans une enceinte d'un générateur à plasma (20),
- mise sous vide de l'enceinte, à une pression comprise entre 10⁻⁶ et 10 mbar,
- injection d'un gaz adapté dans l'enceinte jusqu'à atteindre une pression dans l'enceinte comprise entre 10⁻⁴ et 10² mbar,
- génération d'une décharge de courant électrique au sein de l'enceinte, par l'intermédiaire d'un générateur électrique, afin de générer un plasma,
- exposition de la surface cible (11) de la pièce (10) au plasma durant une durée prédéfinie au moins selon la puissance de la décharge de courant électrique, le gaz injecté dans l'enceinte et le matériau de la surface cible (11), de sorte à détériorer l'état de surface de la surface cible (11) afin d'augmenter sa rugosité pour matifier ladite surface cible (11), ladite étape d'exposition de la surface cible (11) de la pièce (10) au plasma étant réalisée de sorte à finir la réticulation de la partie de la couche de vernis (13) pré-réticulée.

2. Procédé de traitement selon la revendication 1, dans lequel, lors de l'opération de pré-réticulation, la surface cible (11) est exposée au rayonnement ultraviolet durant 5 à 10 secondes.

3. Procédé de traitement selon l'une des revendications 1 ou 2, dans lequel l'enceinte est mise sous vide à une pression comprise entre 0,1 et 1 mbar.

4. Procédé de traitement selon l'une des revendications 1 à 3, dans lequel, lors de l'étape d'injection d'un gaz, de l'argon est injecté dans l'enceinte avec un débit massique compris entre 15 et 25 sccm, jusqu'à obtenir une pression dans l'enceinte comprise entre 0,6 et 0,8 mbar.

5. Procédé de traitement selon la revendication 4, dans lequel le générateur électrique développe une puissance comprise entre 2000 et 2600 W lors de l'étape de génération d'une décharge de courant électrique et l'étape d'exposition de la surface cible (11) est réalisée durant 1 à 2 minutes.

6. Procédé de traitement selon l'une des revendications 1 à 5, dans lequel la couche de vernis (13) présente une unité de brillant mesurée à 60° inférieure à 5 GU.

7. Procédé de traitement selon l'une des revendications 1 à 6, dans lequel, à l'issue de l'étape d'obtention de la surface cible (11) sur la pièce (10), une étape de dépôt d'une couche de masquage est réalisée sur une partie de la surface cible (11) dite « zone masquée », le reste de ladite surface cible (11) étant dite « zone exposée », ladite couche de masquage étant destinée à protéger la zone masquée du plasma.

8. Procédé de traitement selon la revendication 1, dans lequel, lors de l'opération de pré-réticulation de la couche de vernis (13), seule une partie de ladite couche est pré-réticulée, l'autre partie étant entièrement réticulée.

## Patentansprüche

1. Verfahren zur Plasmabehandlung einer Zieloberfläche (11) eines Bauteils (10), das die folgenden Schritte umfasst:
- Erhalten der Zieloberfläche (11) auf dem Bauteil (10), umfassend einen Vorgang des Aufbringens einer Lackschicht (13) auf einem speziellen Bereich der Zieloberfläche (11) und einen Vorgang des Vorvernetzens mindestens eines Teils der Lackschicht (13) durch Aussetzen mindestens eines Teils der Zieloberfläche (11) gegenüber ultravioletter Strahlung,
- Platzieren des Bauteils (10) in einer Kammer eines Plasmagenerators (20),
- Vakuumieren der Kammer auf einen Druck zwischen 10⁻⁶ und 10 mbar,
- Einbringen eines geeigneten Gases in die Kammer, bis ein Druck in der Kammer zwischen 10⁻⁴ und 10² mbar erreicht ist,
- Erzeugen einer Entladung von elektrischem Strom innerhalb der Kammer über einen elektrischen Generator, um ein Plasma zu erzeugen,
- Aussetzen der Zieloberfläche (11) des Bauteils (10) gegenüber dem Plasma für einen vordefinierten Zeitraum, der mindestens von der Leistung der elektrischen Stromentladung, dem in die Kammer eingebrachten Gas und dem Material der Zieloberfläche (11) vordefiniert wird, um den Oberflächenzustand der Zieloberfläche (11) zu verschlechtern, um deren Rauheit zu erhöhen, um die Zieloberfläche (11) zu mattieren, wobei der Schritt des Aussetzens der Zieloberfläche (11) des Bauteils (10) gegenüber dem Plasma so durchgeführt wird, dass das Vernetzen des Bauteils der vorvernetzten Lackschicht (13) abgeschlossen wird.

2. Behandlungsverfahren nach Anspruch 1, wobei die Zieloberfläche (11) während des Vorgangs des Vorvernetzens 5 bis 10 Sekunden lang der ultravioletten Strahlung ausgesetzt wird.

3. Behandlungsverfahren nach einem der Ansprüche 1 oder 2, wobei die Kammer auf einen Druck zwischen 0,1 und 1 mbar vakuumiert wird.

4. Behandlungsverfahren nach einem der Ansprüche 1 bis 3, wobei während des Schritts des Einbringens eines Gases Argon mit einer Massenflussrate zwischen 15 und 25 sccm in die Kammer eingebracht wird, bis in der Kammer ein Druck zwischen 0,6 und 0,8 mbar erreicht wird.

5. Behandlungsverfahren nach Anspruch 4, wobei der Stromgenerator während des Schritts des Erzeugens einer elektrischen Stromentladung eine Leistung zwischen 2000 und 2600 W entwickelt und der Schritt des Aussetzens der Zieloberfläche (11) 1 bis 2 Minuten lang durchgeführt wird.

6. Behandlungsverfahren nach einem der Ansprüche 1 bis 5, wobei die Lackschicht (13) eine bei 60° gemessene Glanzeinheit von weniger als 5 GU aufweist.

7. Behandlungsverfahren nach einem der Ansprüche 1 bis 6, wobei am Ende des Schritts des Erhaltens der Zieloberfläche (11) auf dem Bauteil (10) ein Schritt des Aufbringens einer Maskierungsschicht auf einem Teil der Zieloberfläche (11), der sogenannte "maskierter Bereich", durchgeführt wird, wobei der Rest der Zieloberfläche (11) der sogenannten "freiliegende Bereich" ist, wobei die Maskierungsschicht dazu bestimmt ist, den maskierten Bereich vor dem Plasma zu schützen.

8. Behandlungsverfahren nach Anspruch 1, wobei während des Vorgangs des Vorvernetzens der Lackschicht (13) nur ein Teil der Schicht vorvernetzt wird, während der andere Teil vollständig vernetzt wird.

## Claims

1. Method for plasma treating a target surface (11) of a part (10) including the following steps of:
- obtaining the target surface (11) on the part (10), comprising an operation of depositing a coat of varnish (13) on a dedicated area of the target surface (11) and an operation of pre-crosslinking at least a portion of the coat of varnish (13) by exposing at least a portion of the target surface (11) to ultraviolet radiation;
- placing the part (10) in a chamber of a plasma generator (20),
- evacuating the chamber to a pressure of between 10⁻⁶ and 10 mbar,
- injecting a suitable gas into the chamber until a pressure in the chamber of between 10⁻⁴ and 10² mbar is reached,
- generating an electric current discharge within the chamber, via an electric generator, in order to generate a plasma,
- exposing the target surface (11) of the part (10) to the plasma for a predefined period of time, depending at least on the power of the electric current discharge, the gas injected into the chamber and the material of the target surface (11), so as to deteriorate the surface condition of the target surface (11) in order to increase the roughness thereof to mat said target surface (11), said step of exposing the target surface (11) of the part (10) to the plasma being carried out so as to finish the crosslinking of the portion of the pre-crosslinked varnish coat (13).

2. Treatment method according to claim 1, wherein, during the pre-crosslinking operation, the target surface (11) is exposed to the ultraviolet radiation for 5 to 10 seconds.

3. Treatment method according to one of claims 1 or 2, wherein the chamber is evacuated to a pressure of between 0.1 and 1 mbar.

4. Treatment method according to one of claims 1 to 3, wherein, during the gas injection step, argon is injected into the chamber at a mass flow rate of between 15 and 25 sccm, until a pressure of between 0.6 and 0.8 mbar is reached in the chamber.

5. Treatment method according to claim 4, wherein the electric generator develops a power of between 2,000 and 2,600 W during the step of generating an electric current discharge and the step of exposing the target surface (11) is carried out for 1 to 2 minutes.

6. Treatment method according to one of claims 1 to 5, wherein the varnish coat (13) has a gloss unit measured at 60° of less than 5 GU.

7. Treatment method according to one of claims 1 to 6, wherein, at the end of the step of obtaining the target surface (11) on the part (10), a step of depositing a masking layer is carried out over a portion of the target surface (11) referred to as the "masked area", the remainder of said target surface (11) being referred to as the "exposed area", said masking layer being intended to protect the masked area from the plasma.

8. Treatment method according to claim 1, wherein, during the pre-crosslinking operation for the varnish coat (13), only a portion of said coat is pre-crosslinked, the other portion being fully crosslinked.
